# EUROPEAN PATENT SPECIFICATION

(11) **EP 3 487 323 B1**
(45) Date of publication and mention of the grant of the patent: **30.09.2020**
(21) Application number: 17731898.7
(22) Date of filing: 21.06.2017
(51) Int. Cl.: A24F 47/00

(54) **MANUFACTURING A FLUID PERMEABLE HEATER ASSEMBLY WITH CAP**
HERSTELLUNG EINER FLÜSSIGKEITSDURCHLÄSSIGEN HEIZUNGSANORDNUNG MIT KAPPE
FABRICATION D'UN ENSEMBLE DE CHAUFFAGE PERMÉABLE AUX FLUIDES AVEC CAPUCHON

(30) Priority: 25.07.2016 EP 16180956
(43) Date of publication of application: 29.05.2019
(73) Proprietor: Philip Morris Products S.A., 2000 Neuchâtel (CH)
(72) Inventor: WIDMER, Jean-Marc, 2523 Lignières (CH); FERNANDO, Keethan Dasnavis, 2000 Neuchâtel (CH)
(74) Representative: Ponder, William Anthony John
(86) International application number: PCT/EP2017/065307
(87) International publication number: WO 2018/019486

(56) References cited:
- WO-A1-2015/117701
- CN-U- 203 762 290
- US-A- 6 095 153
- US-A1- 2013 042 865

## Description

The present invention relates to aerosol-generating systems, such as handheld electrically operated smoking systems. In particular, the present invention relates to the manufacturing of heater assemblies for aerosol-generating systems in which the aerosol-forming substrate is liquid and vaporised.

Handheld electrically operated aerosol-generating system are known that consist of a device portion comprising a battery and control electronics, a cartridge portion comprising a supply of aerosol-forming substrate held in a liquid storage portion, and an electrically operated heater assembly acting as a vaporiser. A cartridge comprising both a supply of aerosol-forming substrate held in the liquid storage portion and a vaporiser is sometimes referred to as a "cartomiser". The heater assembly may comprise a fluid permeable heating element that is in contact with a capillary medium like an elongated wick soaked in the liquid aerosol-forming substrate held in the liquid storage portion. The cartridge portion typically comprises not only the supply of aerosol-forming substrate and an electrically operated heater assembly, but also a mouthpiece, which the user sucks on in use to draw aerosol into their mouth.

WO 2015/117701 A1 describes a fluid permeable heater assembly for aerosol-generating systems comprising a substrate comprising an opening through the substrate, an electrically conductive substantially flat filament arrangement arranged over the opening, and a clamping means mechanically fixing the filament arrangement to the substrate.

A heater assembly with a fluid permeable heating element may have a fragile structure. The components of the heater assembly may easily shift during transport, packaging and use. Manufacturing a cartridge with such a heater assembly may be difficult.

It would be desirable to provide an improved heater assembly for an aerosol-generating system that allows easier manufacturing at lower costs and provides a more rigid structure to prevent a shifting of the components of the heater assembly.

According to a first aspect of the present invention there is provided a method for manufacturing a fluid permeable heater assembly, the heater assembly comprising a cap and a substantially flat electrically conductive heating element, the method comprising, in a first step, providing the heating element, and in a second step, over-molding the cap on edge areas of one side of the heating element. The cap comprises a hollow body with a first and a second cap opening. The first cap opening is opposite to the second cap opening. The heating element is mounted on the cap such that the heating element extends across the first cap opening.

The solution provided here is to attach a cap with a hollow body onto the heating element to improve stability of the heating element and to provide guidance for a capillary medium that may be arranged in the hollow body of the cap. The use of a cap may simplify the manufacturing of the heater assembly and may improve the rigidity of the heater assembly.

A further purpose of the heater assembly according to the present invention may be to cap a filled cartridge. The idea is to pre-assemble all parts of the heater assembly and then manipulate this one-piece formed component to ease the closing of the cartridge.

As used herein, "substantially flat" means formed initially in a single plane and not wrapped around or other conformed to fit a curved or other non-planar shape. As used herein, "electrically conductive" means formed from a material having a resistivity of 1x10⁻⁴ Ohm meter, or less. As used herein, "electrically insulating" means formed from a material having a resistivity of 1x10⁴ Ohm meter or more. As used herein, "fluid permeable" in relation to a heater assembly means that the aerosol-forming substrate, in a gaseous phase and possibly in a liquid phase, can readily pass through the heating element of the heater assembly.

The heater assembly comprises a cap formed from a material with a high thermal decomposition temperature and that is able to tolerate rapid temperature changes. The heating element is supported on the cap. Preferably, the cap is molded from plastic granules. The plastic granules may be of polyether ether ketone (PEEK), liquid-crystal polymers (LCP) or any other polymer material. Preferably, the cap material is over-molded on the underside of the heating element. More preferably, the cap is made of VICTREX PEEK via over-molding on a mesh strip. The underside of the heating element is oriented towards the first cap opening. Over-molding the cap onto the underside of the heating element is advantageous, as no further mounting material, such as terminals, is required to fix the heating element on the cap.

Preferably, the cap has a size sufficient to distance the liquid storage portion from the heating element by a distance of at least 1.5 millimeter, and preferably between 3 millimeter and 6 millimeter in order to provide a sufficient temperature drop across the cap. Advantageously, in such an embodiment, the liquid storage portion can be made from a more cost efficient material with a lower thermal decomposition temperature, such as for example polyethylene or polypropylene.

The heater assembly further comprises a substantially flat heating element allowing for simple manufacture. Geometrically, the term "substantially flat" electrically conductive heating element is used to refer to an electrically conductive arrangement of filaments that is in the form of a substantially two dimensional topological manifold. Thus, the substantially flat electrically conductive heating element extends in two dimensions along a surface substantially more than in a third dimension. In particular, the dimensions of the substantially flat heating element in the two dimensions within the surface is at least five times larger than in the third dimension, normal to the surface. An example of a substantially flat heating element is a structure between two substantially imaginary parallel surfaces, wherein the distance between these two imaginary surfaces is substantially smaller than the extension within the surfaces. In some embodiments, the substantially flat heating element is planar. In other embodiments, the substantially flat heating element is curved along one or more dimensions, for example forming a dome shape or bridge shape.

The term "filament" is used throughout the specification to refer to an electrical path arranged between two electrical contacts. A filament may arbitrarily branch off and diverge into several paths or filaments, respectively, or may converge from several electrical paths into one path. A filament may have a round, square, flat or any other form of cross-section. A filament may be arranged in a straight or curved manner.

The term "heating element" is used throughout the specification to refer to an arrangement of one or preferably a plurality of filaments. The heating element may be an array of filaments, for example arranged parallel to each other. The heating element is fluid permeable. The heating element may be cut so as to provide open areas when mounting the heating element across the first cap opening. Preferably, the open areas are manufactured by cutting bevelled window slots out of each side of the heating element.

Preferably, the filaments may form a mesh. The mesh may be woven or non-woven. The mesh may be formed using different types of weave or lattice structures. Alternatively, the electrically conductive heating element consists of an array of filaments arranged parallel to one another. The mesh, array or fabric of electrically conductive filaments may also be characterized by its ability to retain liquid.

In a preferred embodiment, a substantially flat heating element may be constructed from a wire that is formed into a wire mesh. Preferably, the mesh has a plain weave design. Preferably, the heating element is a wire grill made from a mesh strip.

The electrically conductive filaments may define interstices between the filaments and the interstices may have a width of between 10 micrometer and 100 micrometer. Preferably, the filaments give rise to capillary action in the interstices, so that in use, liquid to be vaporized is drawn into the interstices, increasing the contact area between the heating element and the liquid aerosol-forming substrate.

The electrically conductive filaments may form a mesh of size between 60 and 240 filaments per centimeter (+/- 10 percent). Preferably, the mesh density is between 100 and 140 filaments per centimeter (+/- 10 percent). More preferably, the mesh density is approximately 115 filaments per centimeter. The width of the interstices may be between 100 micrometer and 25 micrometer, preferably between 80 micrometer and 70 micrometer, more preferably approximately 74 micrometer. The percentage of open area of the mesh, which is the ratio of the area of the interstices to the total area of the mesh may be between 40percent and 90 percent, preferably between 85 percent and 80 percent, more preferably approximately 82 percent. Throughout this specification, the density of such a mesh is referred to as "first mesh density".

Additionally, the mesh may have one or more sections with increased mesh density, referred to as "second mesh density", where the interstices between the filaments are below 5 micrometer, preferably below 2 micrometer, and more preferably approximately 1 micrometer. The one or more sections of the mesh with increased mesh density are referred to as "dense areas" throughout this specification.

The electrically conductive filaments may have a diameter of between 8 micrometer and 100 micrometer, preferably between 10 micrometer and 50 micrometer, more preferably between 12 micrometer and 25 micrometer. The filaments may have a round cross section or may have a flattened cross-section.

The area of the mesh, array or fabric of electrically conductive filaments may be small, for example less than or equal to 50 square millimeters, preferably less than or equal to 25 square millimeters, more preferably approximately 15 square millimeters. The size is chosen such to incorporate the heating element into a handheld system. Sizing of the mesh, array or fabric of electrically conductive filaments less or equal than 50 square millimeters reduces the amount of total power required to heat the mesh, array or fabric of electrically conductive filaments while still ensuring sufficient contact of the mesh, array or fabric of electrically conductive filaments to the liquid aerosol-forming substrate. The mesh, array or fabric of electrically conductive filaments may, for example, be rectangular and have a length between 2 millimeter to 10 millimeter and a width between 2 millimeter and 10 millimeter. Preferably, the mesh has dimensions of approximately 5 millimeter by 3 millimeter. The mesh or array of electrically conductive filaments may cover an area of between 30 percent and 90 percent of the open area of the first cap opening across which the heating element extends. Preferably, the mesh or array of electrically conductive filaments covers an area of between 50 percent and 70 percent of the open area of the first cap opening. More preferably, the mesh or array of electrically conductive filaments covers an area of between 55 percent and 65 percent of the open area of the first cap opening.

The filaments of the heating element may be formed from any material with suitable electrical properties. Suitable materials include but are not limited to: semiconductors such as doped ceramics, electrically "conductive" ceramics (such as, for example, molybdenum disilicide), carbon, graphite, metals, metal alloys and composite materials made of a ceramic material and a metallic material. Such composite materials may comprise doped or undoped ceramics. Examples of suitable doped ceramics include doped silicon carbides. Examples of suitable metals include titanium, zirconium, tantalum and metals from the platinum group.

Examples of suitable metal alloys include stainless steel, constantan, nickel-, cobalt-, chromium-, aluminum-, titanium-, zirconium-, hafnium-, niobium-, molybdenum-, tantalum-, tungsten-, tin-, gallium-, manganese- and iron-containing alloys, and super-alloys based on nickel, iron, cobalt, stainless steel, Timetal®, iron-aluminum based alloys and iron-manganese-aluminum based alloys. Timetal® is a registered trade mark of Titanium Metals Corporation. The filaments may be coated with one or more insulators. Preferred materials for the electrically conductive filaments are stainless steel and graphite, more preferably 300 series stainless steel like AISI 304, 316, 304L, 316L. Additionally, the electrically conductive heating element may comprise combinations of the above materials. A combination of materials may be used to improve the control of the resistance of the substantially flat heating element. For example, materials with a high intrinsic resistance may be combined with materials with a low intrinsic resistance. This may be advantageous if one of the materials is more beneficial from other perspectives, for example price, machinability or other physical and chemical parameters. Advantageously, a substantially flat filament arrangement with increased resistance reduces parasitic losses. Advantageously, high resistivity heaters allow more efficient use of battery energy.

Preferably, the filaments are made of wire. More preferably, the wire is made of metal, most preferably made of stainless steel.

The electrical resistance of the mesh, array or fabric of electrically conductive filaments of the heating element may be between 0.3 Ohms and 4 Ohms. Preferably, the electrical resistance is equal or greater than 0.5 Ohms. More preferably, the electrical resistance of the mesh, array or fabric of electrically conductive filaments is between 0.6 Ohms and 0.8 Ohms, and most preferably about 0.68 Ohms. The electrical resistance of the mesh, array or fabric of electrically conductive filaments is preferably at least an order of magnitude, and more preferably at least two orders of magnitude, greater than the electrical resistance of electrically conductive contact areas. This ensures that the heat generated by passing current through the heating element is localized to the mesh or array of electrically conductive filaments. It is advantageous to have a low overall resistance for the heating element if the system is powered by a battery. A low resistance, high current system allows for the delivery of high power to the heating element. This allows the heating element to heat the electrically conductive filaments to a desired temperature quickly.

The hollow body of the cap may be configured to hold a capillary medium. Preferably, the heater assembly comprises a host material piece made from the capillary medium for retaining the liquid aerosol-forming substrate. At least a portion of the host material piece may be arranged in the hollow body between the first and the second cap opening.

Advantageously, the cap and the host material piece may be sized to have a cross-sectional area of approximately the same size. As used here, approximately the same size means that a cross-sectional area of the cap comprising the first cap opening may be up to 30percent smaller or larger than the capillary material. The shape of the interior space of the hollow body of the cap may also be similar to the shape of the capillary material such that the assembly and the material substantially overlap. Preferably, the host material piece is substantially the same size and shape as the interior space of the hollow body. Preferably, the interior space of the hollow body is substantially of cylindrical shape. The volume of the interior space of the hollow body may be between 50 cubic millimeter and 500 cubic millimeter, preferably between 100 cubic millimeter and 250 cubic millimeter, more preferably approximately 150 cubic millimeter.

The host material piece may be provided at least partially in contact with the heating element. When the assembly and the material are substantially similar in size and shape, manufacturing can be simplified and the robustness of the manufacturing process improved.

Preferably, the heater assembly comprises a transport material piece made from a capillary medium for transporting liquid aerosol-forming substrate from the host material piece to the heating element. The transport material piece may be provided in contact with the heating element. Preferably, the transport material piece is arranged between the heating element and the host material piece. In this case, the host material is not in direct contact with the heating element.

The transport material piece may be made of a material capable of guaranteeing that there is liquid aerosol-forming substrate in contact with at least a portion of the surface of the heating element that extends across the first cap opening. The transport material piece may be in contact with the electrically conductive filaments. The transport material piece may extend into interstices between the filaments. The heating element may draw liquid aerosol-forming substrate into the interstices by capillary action. Preferably, the transport material piece is in contact with the electrically conductive filaments over substantially the entire extent of the open area of the first cap opening.

A capillary material is a material that actively conveys liquid from one end of the material to another. The capillary material may be oriented, directly or indirectly via another capillary medium, in contact with a liquid storage portion to convey liquid aerosol-forming substrate towards the heating element.

The capillary material may include even more than two capillary materials including one or more layers of the capillary material directly in contact with the mesh, array or fabric of electrically conductive filaments of the heating element in order to promote aerosol generation.

Preferably, the cap comprises a holder with a holder opening. The holder may be a planar disk covering at least the first cap opening and having a thickness between 0.25 millimeter and 5 millimeter, preferably between 0.5 millimeter and 2.5 millimeter, and more preferably approximately 0.8 millimeter. The holder opening may have a size of between 10 square millimeters and 50 square millimeters, preferably between 20 square millimeters and 30 square millimeters, and more preferably approximately 25 square millimeters. The holder may cover the first cap opening such that the holder opening coincides with at least a portion of the first cap opening. The heating element may be mounted on the holder. A surface of the holder is in contact with the heating element and represents a contact area that enlarges the contact area as compared to a cap without a holder. The holder reduces the size of the first cap opening to the size of the holder opening. Enlarging the contact area between holder and heating element may improve rigidity of the heater assembly and may ease the assembly thereof. Preferably, the cap including the holder is over-molded on the underside of the heating element.

Preferably, the cap is integrally formed. The integrally formed cap may include the holder.

The heating element may have at least two electrically conductive contact areas. The electrically conductive contact areas may be positioned at an edge area of the heating element.

Preferably, the at least two electrically conductive contact areas are each positioned at a dense area of the heating element. The electrically conductive contact areas may be positioned on extremities of the heating element. An electrically conductive contact area may be fixed directly to the electrically conductive filaments. An electrically conductive contact area may comprise a tin patch. Alternatively, an electrically conductive contact area may be integral with the electrically conductive filaments.

Preferably, the step of providing of a heating element comprises providing a mesh strip. The mesh strip may comprise an alternating sequence of mesh sections of a first mesh density and a second mesh density. Having sections of a higher density may increase the stability of the mesh while handling it.

The step of providing the heating element may further comprise die cutting bevelled window slots out of each side of a mesh section of the first mesh density, and removing loose wires from the cut mesh sections of the first mesh density.

Preferably, the first mesh density is lower than the second mesh density.

Preferably, the step of over-molding of a cap on edge areas of one side of the heating element, comprises pre-heating plastic granules, injecting the plastic granules into a mold for making the cap, and over-molding the cap onto the underside of a mesh section of the second mesh density.

Preferably, the step of over-molding a cap on edge areas of one side of the heating element further comprises cutting the heater assembly off the mesh strip, and removing debris from the heater assembly.

Preferably, the step of cutting the heater assembly off the mesh strip comprises die cutting a mesh off the mesh strip, wherein the heating element comprises the mesh, and wherein the mesh is cut within a mesh section of the second mesh density such that the mesh comprises a mesh section of the first mesh density that is limited by mesh sections of the second mesh density on each of the two ends of the cut mesh.

Preferably, the method for manufacturing a fluid permeable heater assembly according to the first aspect of the present invention further comprises joining at least two electrically conductive contact areas each onto an edge area of the other side of the heating element.

The step of joining at least two electrically conductive contact areas each onto an edge area of the other side of the heating element may comprise providing a tin foil strip, cutting off tin foil patches from a tin foil strip in a size that matches the shape and the size of the mesh section of the second mesh density, and compressing a tin foil patch onto the mesh section of the second mesh density. It may be advantageous that the foil strip is made of a softer material than the material of the heating element.

Preferably, the method for manufacturing a fluid permeable heater assembly according to the first aspect of the present invention further comprises inspecting the heater assembly.

Preferably, the step of inspecting the heater assembly comprises transporting the heater assembly to inspection stations, measuring the electrical resistance of the heating element of the manufactured heater assembly, visually inspecting the heating element for correct wire count, clean cut-off of the mesh, correct mesh integrity, debris and tin foil attachment, and rejecting the heater assembly if the heater assembly fails at least one of the expected electrical resistance of the heating element and the expected result of the visual inspection.

According to a second aspect of the present invention there is provided an apparatus for manufacturing a fluid permeable heater assembly according to the first aspect.

In order to manufacture a heater assembly comprising a cap and a substantially flat electrically conductive heating element with a mesh, the apparatus for manufacturing a fluid permeable heater assembly may comprise at least one of the following equipment units:
- a mesh strip bobbin feeding unit for providing a mesh strip, the mesh strip comprising an alternating sequence of mesh sections of a first mesh density and of a second mesh density,
- a tin foil strip bobbin feeding unit for providing a tin foil strip,
- a tin foil cutting station for indexing a length of tin foil to be positioned over the mesh section of the second mesh density and for cutting tin patches from the provided tin foil strip,
- a tin foil pressing station for compressing to join the tin patches onto the top surface of the mesh section of the second mesh density,
- a mesh window cutting station for die cutting bevelled window slots out of each side of a mesh section of the first mesh density,
- a first cleaning station for removing loose wires from the cut mesh sections of the first mesh density, small particles, dust, or debris by cleaning with air pressure and vacuuming the surfaces of the cut mesh sections to remove debris,
- an injection molding machine for pre-heating plastic granules and injecting the same into a mold for making the cap,
- a mesh injection over-molding tool (possibly having a single cavity or several cavities) for over-molding the cap onto the underside of the mesh section of the second mesh density,
- a heater assembly cut-off station for cutting the heater assembly off the mesh strip by die cutting a mesh off the mesh strip, the heating element comprising the mesh, and the mesh being cut within a mesh section of the second mesh density such that the mesh comprises a mesh section of the first mesh density that is limited by mesh sections of the second mesh density on each of the two ends of the cut mesh,
- a second cleaning station for removing loose wires from the mesh by cleaning with air pressure and vacuuming the surfaces of the heater assembly to remove debris,
- a transfer unit for transporting the heater assembly to a heater assembly inspection station, the heater assembly inspection station may comprise a heater assembly resistance measuring station, a heater assembly vision inspection station and a heater assembly rejection station,
- a mesh stating pressure testing station,
- a heater assembly resistance measuring station for measuring the electrical resistance of the mesh and the tin foil strip of the manufactured heater assembly,
- a heater assembly vision inspection for visually inspecting the heater assembly, and
- a heater assembly rejection station for rejecting a heater assembly that is out of specification.

In a preferred manufacturing process, the equipment automatically manufactures a heater assembly from a mesh strip, a tin foil strip, and from plastic granules. The heater assembly comprises a cap and a substantially flat electrically conductive heating element.

A preferred manufacturing process according to the first aspect of the present invention may comprise a manual loading of at least one of a mesh strip bobbin, a tin foil strip bobbin, and plastic granules. The preferred manufacturing process may further comprise at least one of the method steps that are automatically executed by the manufacturing equipment:
- providing a mesh strip, the mesh strip comprising an alternating sequence of mesh sections of a first mesh density and of a second mesh density,
- providing a tin foil strip,
- indexing a length of tin foil to be positioned over the mesh section of the second mesh density,
- cutting tin patches from the provided tin foil strip,
- compressing to join the tin patches onto the top surface of the mesh section of the second mesh density,
- die cutting bevelled window slots out of each side of a mesh section of the first mesh density,
- removing loose wires from the cut mesh sections of the first mesh density, small particles, dust, or debris by cleaning with air pressure and vacuuming the surfaces of the cut mesh sections to remove debris,
- pre-heating plastic granules,
- injecting the plastic granules into a mold for making the cap,
- over-molding the cap onto the underside of a mesh section of the second mesh density,
- cutting the heater assembly off the mesh strip by die cutting a mesh off the mesh strip, the heating element comprising the mesh, and the mesh being cut within a mesh section of the second mesh density such that the mesh comprises a mesh section of the first mesh density that is limited by mesh sections of the second mesh density on each of the two ends of the cut mesh,
- removing loose wires from the mesh, small particles, dust, or debris by cleaning with air pressure and vacuuming the surfaces of the mesh to remove debris,
- transporting the heater assembly to an inspection station,
- measuring the electrical resistance of the mesh of the manufactured heater assembly,
- visually inspecting the heater assembly for correct wire count, clean cut-off of the mesh, correct mesh integrity, debris and tin foil attachment, and
- rejecting the heater assembly if it is out of specification.

Features described in relation to one aspect may equally be applied to other aspects of the invention.

Embodiments of the invention will now be described, by way of example only, with reference to the accompanying drawings, in which:
Figure 1A is a perspective top side view of a heater assembly as manufactured in accordance with an embodiment of the present invention;
Figure 1B is a perspective bottom side view of a heater assembly as manufactured in accordance an embodiment of the present invention;
Figure 1C is an exploded perspective view of a heater assembly as manufactured in accordance an embodiment of the present invention;
Figure 2 is a cross-sectional, top side and perspective view of a cap and a holder as manufactured in accordance with an embodiment of the present invention;
Figure 3 is a top side view of a holder, a heating element, and contact areas as manufactured in accordance with an embodiment of the present invention;
Figure 4 is a top side view of a mesh having two different mesh densities as manufactured in accordance with an embodiment of the present invention;
Figure 5 is a top side view of a mesh strip for manufacturing a mesh in accordance with an embodiment of the present invention; and
Figure 6 is an exploded perspective view of a cartridge for an aerosol-generating system that comprises a heater assembly as manufactured in accordance with an embodiment of the present invention.

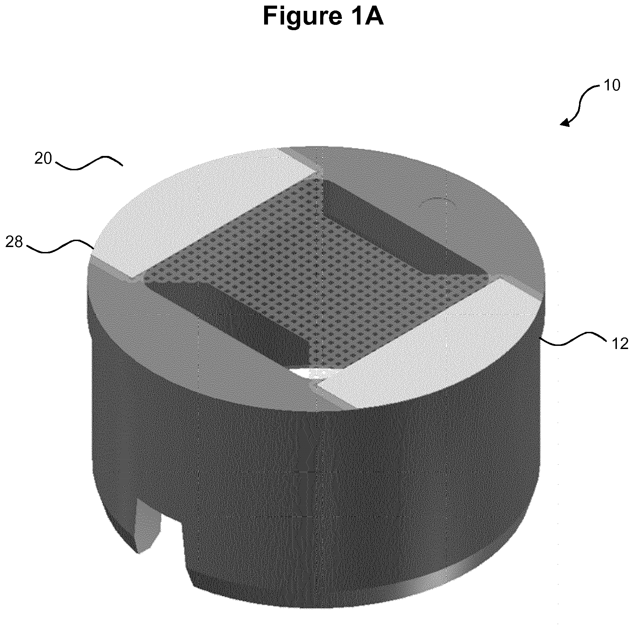

Fig. 1A shows a heater assembly 10 comprising a cap 12 with a first cap opening 16 on the top side of the cap and a second cap opening 18 on the bottom side of the cap 12. The first cap opening 16 is covered by a holder 28 with a holder opening 30. The heater assembly 10 further comprises a heating element 20 which extends across the holder opening 30.

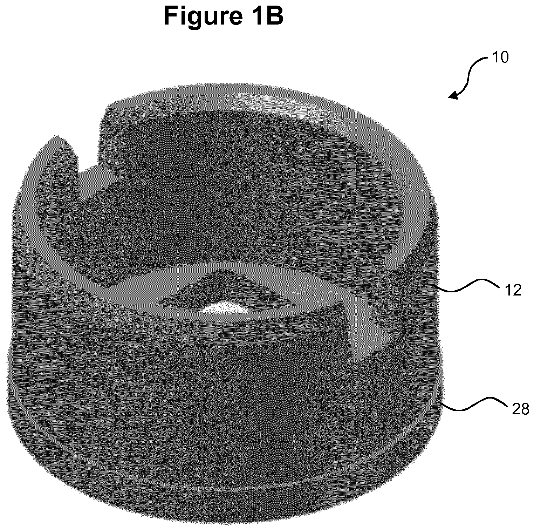

Fig. 1B shows the heating assembly 10 from a bottom view. The interior space of the hollow body 14 of the cap 12 becomes visible.

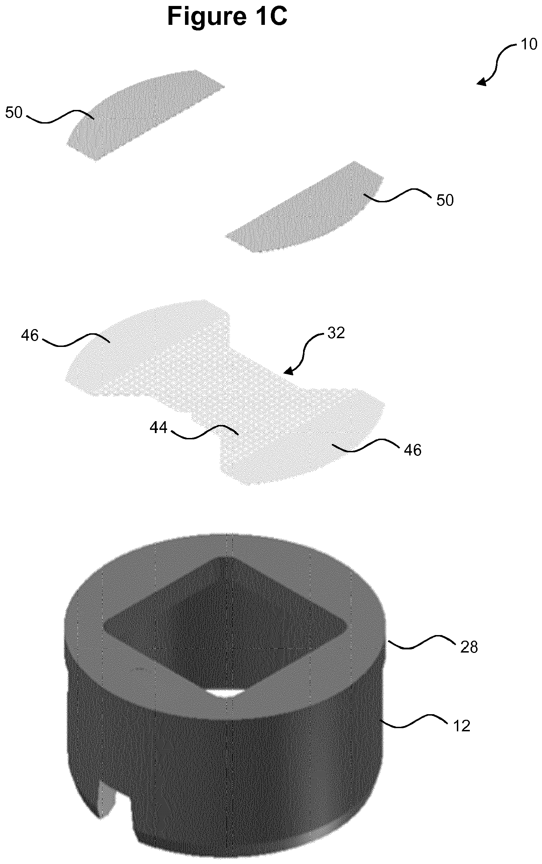

Fig. 1C shows the components of the heating element 20 comprising a mesh 32. The mesh 32 has a first mesh section 44 of a first mesh density and, on each of its two extremities, a second mesh section 46 of a second mesh density, wherein the second mesh density is higher than the first density. A tin foil patch 50 is joined with each of the two mesh sections 46 of the second mesh density. The heating element 20, respectively its mesh 32, is arranged across the holder opening 30 of the holder 28 on top of the cap 12. The entire mesh section 44 of the first mesh density is arranged above the holder opening 30.

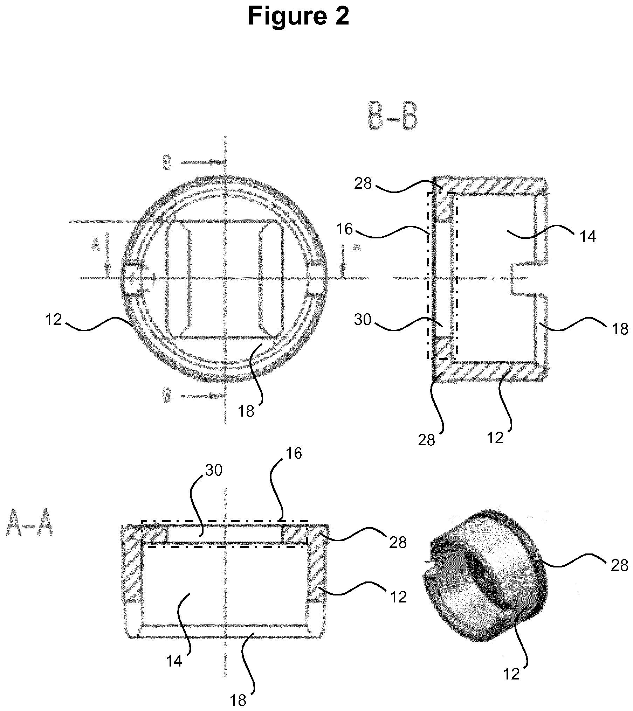

Fig. 2 shows the cap 12 and its holder 28. The holder 28 may be a separate part. Preferably, the holder 28 is an integral part of the cap 12. The interior body of the hollow body 14 of the cap 12 is of cylindrical shape. The cuts A-A and B-B of Fig. 2 show cap 12 and its holder 28 integrally formed, wherein the perspective view of Fig. 2 shows holder 28 as a separate part. Cuts A-A and B-B of Fig. 2 show the first cap opening 16 which is partially closed by holder 28 so that only a smaller portion, referred to as holder opening 30, of the first cap opening 16 remains open and across which a heating element may extend.

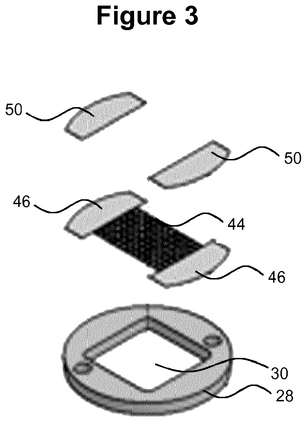

Fig. 3 shows the holder 28 formed as a separate part of cap 12, wherein the heating element 20 is mounted such that the mesh section 44 of the first mesh density extends across the holder opening 30.

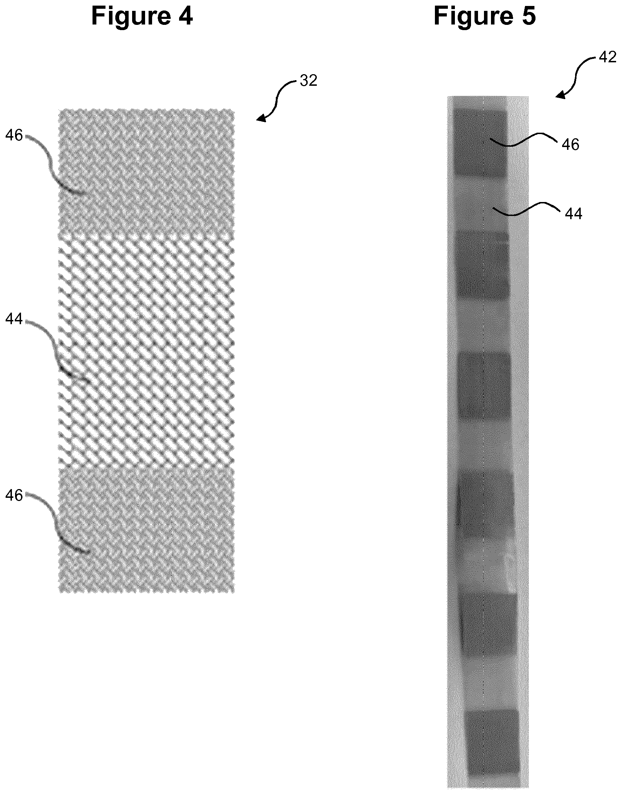

Fig. 4 shows a mesh 32 of the heating element 20. The mesh 32 comprises a mesh section 44 of a first mesh density and, on each of its two extremities, a second mesh section 46 of a second mesh density.

Fig. 5 shows a mesh strip 42 from which a number of meshes 32 may be die cut.

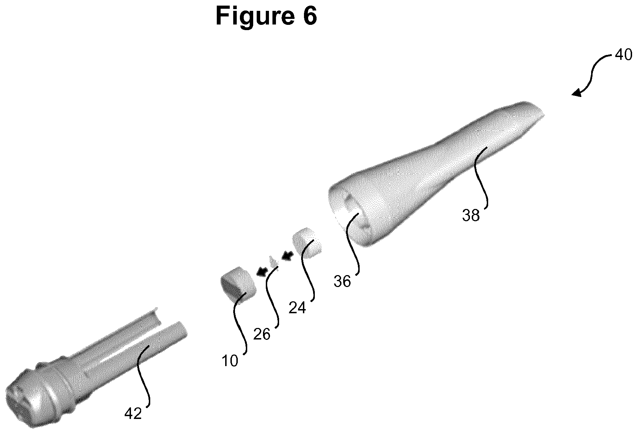

Fig. 6 shows a cartridge 40 according to an embodiment of the present invention. The cartridge 40 comprises the heater assembly 10 with a cap 12 and a heating element 20 arranged on a holder 28 of the cap 12. A transport material piece 26 is arranged in a holder opening 30 of the holder 28. A host material piece 24 is arranged in the interior space of the hollow body 14 of the cap 12. The cap 12 acts as a rigid housing for the transport material piece 26 and the host material piece 24. The cartridge 40 further comprises a liquid storage portion for storing liquid aerosol-forming substrate. A retainer 42 is used for retaining the components of the heater assembly 10 and for keeping the heater assembly 10 in contact with the liquid storage portion 36 via the transport material piece 26 and the host material piece 24. Furthermore, the cartridge 40 comprises a mouth piece 38 in which the liquid storage portion 36 is arranged.

The exemplary embodiments described above illustrate but are not limiting. In view of the above discussed exemplary embodiments, other embodiments consistent with the above exemplary embodiments will now be apparent to one of ordinary skill in the art.

## Claims

1. A method for manufacturing a fluid permeable heater assembly (10), the heater assembly (10) comprising a cap (12) and a substantially flat electrically conductive heating element (20), the method comprising:
providing the heating element (20); and
over-molding the cap (12) on edge areas of one side of the heating element (20), wherein the cap (12) comprises a hollow body (14) with a first (16) and a second (18) cap opening, wherein the first cap opening (16) is opposite to the second cap opening (18), and wherein the heating element (20) is mounted on the cap (12) such that the heating element (20) extends across the first cap opening (16).

2. The method according to claim 1, wherein providing the heating element (20) comprises:
providing a mesh strip (42), wherein the mesh strip (42) comprises an alternating sequence of mesh sections (44, 46) of a first mesh density and a second mesh density.

3. The method according to claim 2, wherein providing the heating element (20) further comprises:
die cutting bevelled window slots out of each side of a mesh section (44) of the first mesh density, and
removing loose wires from the cut mesh sections (44) of the first mesh density.

4. The method according to claim 2 or claim 3, wherein the first mesh density is lower than the second mesh density.

5. The method according to any of claims 2 to 4, wherein over-molding a cap (12) on edge areas of one side of the heating element (20) comprises:
pre-heating plastic granules,
injecting the plastic granules into a mold for making the cap (12), and
over-molding the cap (12) onto the underside of a mesh section (46) of the second mesh density.

6. The method according to claim 5, wherein over-molding a cap (12) on edge areas of one side of the heating element (20) further comprises:
cutting the heater assembly (10) off the mesh strip (42), and removing loose wires from the heating element (20).

7. The method according to claim 6, wherein cutting the heater assembly (10) off the mesh strip (42) comprises:
die cutting a mesh (32) off the mesh strip (42), wherein the heating element (20) comprises the mesh (32), and wherein the mesh (32) is cut within a mesh section (46) of the second mesh density such that the mesh (32) comprises a mesh section (44) of the first mesh density that is limited by mesh sections (46) of the second mesh density on each of the two ends of the cut mesh (32).

8. The method according to any of claims 2 to 7, further comprising:
joining at least two electrically conductive contact areas (34) each onto an edge area of the other side of the heating element (20).

9. The method according to claim 8, wherein joining at least two electrically conductive contact areas (34) each onto an edge area of the other side of the heating element (20) comprises:
providing a tin foil strip (48);
cutting off tin foil patches (50) from a tin foil strip (48) in a size that matches the shape and the size of the mesh section (46) of the second mesh density; and
compressing a tin foil patch (50) onto the mesh section (46) of the second mesh density.

10. The method according to any of claims 1 to 9, further comprising:
inspecting the heater assembly (10).

11. The method according to claim 10, wherein inspecting the heater assembly (10) comprises:
transporting the heater assembly (10) to inspection stations,
measuring the electrical resistance of the heating element (20) of the manufactured heater assembly,
visually inspecting the heating element (20) for correct wire count, clean cut-off of the mesh, correct mesh integrity, debris and tin foil attachment, and
rejecting the heater assembly (10) if the heater assembly (10) fails at least one of the expected electrical resistance of the heating element (20) and the expected result of the visual inspection.

12. An apparatus for manufacturing a fluid permeable heater assembly (10), the heater assembly (10) comprising a cap (12) and a substantially flat electrically conductive heating element (20), the apparatus comprising:
a heating element manufacturing unit for providing the heating element (20); and
a mesh injection over-molding tool for over-molding the cap (12) on edge areas of one side of the heating element (20), wherein the cap (12) comprises a hollow body (14) with a first (16) and a second (18) cap opening, wherein the first cap opening (16) is opposite to the second cap opening (18), and wherein the heating element (20) is mounted on the cap (12) such that the heating element (20) extends across the first cap opening (16).

13. The apparatus according to claim 12, wherein the heating element manufacturing unit comprises:
a mesh strip bobbin feeding unit for providing a mesh strip (42), the mesh strip comprising an alternating sequence of mesh sections of a first mesh density and of a second mesh density; and
a heater assembly cut-off station for cutting the heater assembly (10) off the mesh strip (42) by die cutting a mesh (32) off the mesh strip (42), the heating element (20) comprising the mesh (32), and the mesh (32) being cut within a mesh section (46) of the second mesh density such that the mesh comprises a mesh section (44) of the first mesh density that is limited by mesh sections (46) of the second mesh density on each of the two ends of the cut mesh (32).

14. The apparatus according to claim 13, further comprising:
an injection molding machine for pre-heating plastic granules and injecting the same into a mold for making the cap (12);
wherein the mesh injection over-molding tool is configured to over-mold the cap (12) onto the underside of a mesh section (46) of the second mesh density.

15. The apparatus according to any of claims 12 to 14, wherein the apparatus is configured to perform the method of any of claims 1 to 11.

## Patentansprüche

1. Verfahren zur Herstellung einer fluidundurchlässigen Heizvorrichtungsbaugruppe (10), wobei die Heizvorrichtungsbaugruppe (10) eine Kappe (12) und ein im Wesentlichen flaches elektrisch leitfähiges Heizelement (20) aufweist, wobei das Verfahren aufweist:
Vorsehen des Heizelements (20); und
Überspritzen der Kappe (12) an Kantenbereichen der einen Seite des Heizelements (20), wobei die Kappe (12) einen Hohlkörper (14) mit einer ersten (16) und einer zweiten (18) Kappenöffnung aufweist, wobei die erste Kappenöffnung (16) der zweiten Kappenöffnung (18) gegenüberliegt, und wobei das Heizelement (20) derart an der Kappe (12) angebracht ist, dass sich das Heizelement (20) über die erste Kappenöffnung (16) erstreckt.

2. Verfahren nach Anspruch 1, wobei das Vorsehen des Heizelements (20) aufweist:
Vorsehen eines Netzstreifens (42), wobei der Netzstreifen (42) eine abwechselnde Folge von Netzabschnitten (44, 46) einer ersten Netzdichte und einer zweiten Netzdichte aufweist.

3. Verfahren nach Anspruch 2, wobei das Vorsehen des Heizelements (20) ferner aufweist:
Stanzen von angefasten Fensterschlitzen aus jeder Seite eines Netzabschnitts (44) der ersten Netzdichte, und
Entfernen loser Drähte aus den geschnittenen Netzabschnitten (44) der ersten Netzdichte.

4. Verfahren nach Anspruch 2 oder Anspruch 3, wobei die erste Netzdichte niedriger ist als die zweite Netzdichte.

5. Verfahren nach einem der Ansprüche 2 bis 4, wobei das Überspritzen einer Kappe (12) auf Kantenbereichen einer Seite des Heizelements (20) Folgendes aufweist:
Vorwärmung von Kunststoffgranulat,
Einspritzen des Kunststoffgranulats in die Form zur Herstellung der Kappe (12), und
Überspritzen der Kappe (12) auf die Unterseite eines Netzabschnitts (46) der zweiten Netzdichte.

6. Verfahren nach Anspruch 5, wobei das Überspritzen einer Kappe (12) auf Kantenbereichen einer Seite des Heizelements (20) ferner aufweist:
Abtrennen der Heizvorrichtungsbaugruppe (10) von dem Netzstreifen (42) und das Entfernen loser Drähte von dem Heizelement (20).

7. Verfahren nach Anspruch 6, wobei das Abtrennen der Heizvorrichtungsbaugruppe (10) von dem Netzstreifen (42) aufweist:
Stanzen eines Netzes (32) aus dem Netzstreifen (42), wobei das Heizelement (20) das Netz (32) aufweist, und wobei das Netz (32) innerhalb eines Netzabschnitts (46) der zweiten Netzdichte derart geschnitten ist, dass das Netz (32) einen Netzabschnitt (44) der ersten Netzdichte aufweist, der durch Netzabschnitte (46) der zweiten Netzdichte an jedem der beiden Enden des geschnittenen Netzes (32) begrenzt ist.

8. Verfahren nach einem der Ansprüche 2 bis 7, ferner aufweisend:
Verbinden von zumindest zwei elektrisch leitenden Kontaktflächen (34) auf jeweils einen Kantenbereich der anderen Seite des Heizelements (20).

9. Verfahren nach Anspruch 8, wobei das Verbinden von zumindest zwei elektrisch leitenden Kontaktflächen (34) auf jeweils einen Kantenbereich der anderen Seite des Heizelements (20) aufweist:
Vorsehen eines Zinnfolienstreifens (48);
Abschneiden der Zinnfolienpatches (50) von einem Zinnfolienstreifen (48) in einer Größe, die der Form und der Größe des Netzabschnitts (46) der zweiten Netzdichte entspricht; und
Verdichten eines Zinnfolienpatches (50) auf einem Netzabschnitt (46) der zweiten Netzdichte.

10. Verfahren nach einem der Ansprüche 1 bis 9, ferner aufweisend:
Prüfen der Heizvorrichtungsbaugruppe (10).

11. Verfahren nach Anspruch 10, wobei das Prüfen der Heizvorrichtungsbaugruppe (10) aufweist:
Transportieren der Heizvorrichtungsbaugruppe (10) zu Inspektionsstationen,
Messen des elektrischen Widerstandes des Heizelements (20) der hergestellten Heizvorrichtungsbaugruppe,
visuelles Prüfen des Heizelements (20) zur korrekten Drahtzählung, sauberes Abschneiden des Netzes, korrekte Netzintegrität, Schutt- und Zinnfolien-Befestigung, und
Zurückweisen der Heizvorrichtungsbaugruppe (10), wenn die Heizvorrichtungsbaugruppe (10) bei zumindest einem des erwarteten elektrischen Widerstands des Heizelements (20) ausfällt und das erwartete Ergebnis der visuellen Prüfung nicht besteht.

12. Vorrichtung zur Herstellung einer fluidundurchlässigen Heizvorrichtungsbaugruppe (10), wobei die Heizvorrichtungsbaugruppe (10) eine Kappe (12) und ein im Wesentlichen flaches elektrisch leitfähiges Heizelement (20) aufweist, wobei die Vorrichtung aufweist:
Heizelement-Herstellungseinheit zum Vorsehen des Heizelements (20); und
Netzeinspritzwerkzeug zum Überspritzen der Kappe (12) an Kantenbereichen einer Seite des Heizelements (20), wobei die Kappe (12) einen Hohlkörper (14) mit einer ersten (16) und einer zweiten (18) Kappenöffnung aufweist, wobei die erste Kappenöffnung (16) der zweiten Kappenöffnung (18) gegenüberliegt, und wobei das Heizelement (20) derart an der Kappe (12) angebracht ist, dass sich das Heizelement (20) über die erste Kappenöffnung (16) erstreckt.

13. Vorrichtung nach Anspruch 12, wobei die Heizelement-Herstellungseinheit Folgendes aufweist:
Netzstreifenspulen-Zuführeinheit zum Bereitstellen eines Netzstreifens (42), wobei der Netzstreifen eine abwechselnde Folge von Netzabschnitten einer ersten Netzdichte und einer zweiten Netzdichte aufweist; und
Trennstation für eine Heizvorrichtungsbaugruppe zum Abtrennen der Heizvorrichtungsbaugruppe (10) von dem Netzstreifen (42) durch Stanzen eines Netzes (32) aus dem Netzstreifen (42), wobei das Heizelement (20) das Netz (32) aufweist, und wobei das Netz (32) innerhalb eines Netzabschnitts (46) der zweiten Netzdichte derart geschnitten ist, dass das Netz einen Netzabschnitt (44) der ersten Netzdichte aufweist, der durch Netzabschnitte (46) der zweiten Netzdichte an jedem der beiden Enden des geschnittenen Netzes (32) begrenzt ist.

14. Vorrichtung nach Anspruch 13, ferner aufweisend:
Einspritzformmaschine zum Vorwärmen von Kunststoffgranulat und zum Einspritzen desselben in eine Form zum Herstellen der Kappe (12);
wobei das Überspritzwerkzeug zum Netzeinspritzen so ausgelegt ist, dass es die Kappe (12) auf die Unterseite eines Netzabschnitts (46) der zweiten Netzdichte überspritzt.

15. Vorrichtung nach einem der Ansprüche 12 bis 14, wobei die Vorrichtung so ausgelegt ist, dass sie das Verfahren nach einem der Ansprüche 1 bis 11 ausführt.

## Revendications

1. Procédé de fabrication d'un ensemble de chauffage perméable aux fluides (10), l'ensemble de chauffage (10) comprenant un capuchon (12) et un élément de chauffage électriquement conducteur sensiblement plat (20), le procédé comprenant :
la fourniture de l'élément de chauffage (20) ; et
le surmoulage du capuchon (12) sur les zones de bord d'un côté de l'élément de chauffage (20), dans lequel le capuchon (12) comprend un corps creux (14) avec une première (16) et une deuxième ouverture du capuchon (18), dans lequel la première ouverture du capuchon (16) est opposée à la deuxième ouverture du capuchon (18), et dans lequel l'élément de chauffage (20) est monté sur le capuchon (12) de telle sorte que l'élément de chauffage (20) s'étend sur la première ouverture du capuchon (16).

2. Procédé selon la revendication 1, dans lequel la fourniture de l'élément de chauffage (20) comprend :
la fourniture d'une bande de maille (42), dans lequel la bande de maille (42) comprend une séquence alternée de sections de la maille (44, 46) d'une première densité de maille et d'une deuxième densité de maille.

3. Procédé selon la revendication 2, dans lequel la fourniture de l'élément de chauffage (20) comprend en outre :
la découpe des fentes de fenêtre biseautées sur chaque côté d'une section de maille (44) de la première densité de maille, et
l'élimination des fils lâches des sections de la maille coupées (44) de la première densité de maille.

4. Procédé selon la revendication 2 ou la revendication 3, dans lequel la première densité de maille est inférieure à la deuxième densité de maille.

5. Procédé selon l'une quelconque des revendications 2 à 4, dans lequel le surmoulage d'un capuchon (12) sur les zones de bord d'un côté de l'élément de chauffage (20) comprend :
le préchauffage des granules de plastique,
l'injection des granules de plastique dans un moule pour fabriquer le capuchon (12), et
le surmoulage du capuchon (12) sur la face inférieure d'une section de la maille (46) de la deuxième densité de maille.

6. Procédé selon la revendication 5, dans lequel le surmoulage d'un capuchon (12) sur les zones de bord d'un côté de l'élément de chauffage (20) comprend en outre :
le coupage de l'ensemble de chauffage (10) hors de la bande de maille (42) et l'élimination des fils lâches de l'élément de chauffage (20).

7. Procédé selon la revendication 6, dans lequel la découpe de l'ensemble de chauffage (10) hors de la bande de maille (42) comprend :
la découpe d'une maille (32) hors de la bande de maille (42), dans lequel l'élément de chauffage (20) comprend la maille (32), et dans lequel la maille (32) est coupée dans une section de la maille (46) de la deuxième densité de maille de telle sorte que la maille (32) comprend une section de la maille (44) de la première densité de maille qui est limitée par les sections de la maille (46) de la deuxième densité de maille sur chacune des deux extrémités de la maille coupée (32).

8. Procédé selon l'une quelconque des revendications 2 à 7, comprenant en outre :
la jointure d'au moins deux zones de contact électriquement conductrices (34) chacune sur une zone de bord de l'autre côté de l'élément de chauffage (20).

9. Procédé selon la revendication 8, dans lequel la jointure d'au moins deux zones de contact électriquement conductrices (34) chacune sur une zone de bord de l'autre côté de l'élément de chauffage (20) comprend :
la fourniture d'une bande de feuille étamée (48) ;
le coupage des patchs de feuille étamée (50) à partir d'une bande de feuille étamée (48) dans une taille qui correspond à la forme et à la taille de la section de la maille (46) de la deuxième densité de maille ; et
la compression d'un patch de feuille étamée (50) sur la section de la maille (46) de la deuxième densité de maille.

10. Procédé selon l'une quelconque des revendications 1 à 9, comprenant en outre :
l'inspection de l'ensemble de chauffage (10).

11. Procédé selon la revendication 10, dans lequel l'inspection de l'ensemble de chauffage (10) comprend :
le transport de l'ensemble de chauffage (10) vers les stations d'inspection,
la mesure de la résistance électrique de l'élément de chauffage (20) de l'ensemble de chauffage fabriqué,
l'inspection visuelle de l'élément de chauffage (20) pour le comptage correct des fils, la découpe propre de la maille, l'intégrité correcte de la maille, la fixation des débris et de la feuille étamée, et
le rejet de l'ensemble de chauffage (10) si l'ensemble de chauffage (10) échoue à au moins une de la résistance électrique attendue de l'élément de chauffage (20) et le résultat attendu de l'inspection visuelle.

12. Appareil pour la fabrication d'un ensemble de chauffage perméable aux fluides (10), l'ensemble de chauffage (10) comprenant un capuchon (12) et un élément de chauffage électriquement conducteur sensiblement plat (20), l'appareil comprenant :
une unité de fabrication de l'élément de chauffage pour fournir l'élément de chauffage (20) ; et
un outil de surmoulage d'injection de la maille pour le surmoulage du capuchon (12) sur les zones de bord d'un côté de l'élément de chauffage (20), dans lequel le capuchon (12) comprend un corps creux (14) avec une première (16) et une deuxième (18) ouverture du capuchon, dans lequel la première ouverture du capuchon (16) est opposée à la deuxième ouverture du capuchon (18), et dans lequel l'élément de chauffage (20) est monté sur le capuchon (12) de telle sorte que l'élément de chauffage (20) s'étend à travers la première ouverture du capuchon (16).

13. Appareil selon la revendication 12, dans lequel l'unité de fabrication de l'élément de chauffage comprend :
une unité d'alimentation de bobine de bande de maille pour fournir une bande de maille (42), la bande de maille comprenant une séquence alternée de sections de maille d'une première densité de maille et d'une deuxième densité de maille ; et
une station de coupure de l'ensemble de chauffage pour couper l'ensemble de chauffage (10) de la bande de maille (42) en découpant une maille (32) de la bande de maille (42), l'élément de chauffage (20) comprenant la maille (32), et la maille (32) étant coupée dans une section de maille (46) de la deuxième densité de maille de telle sorte que la maille comprend une section de maille (44) de la première densité de maille qui est limitée par des sections de la maille (46) de la deuxième densité de maille sur chacune des deux extrémités de la maille découpée (32).

14. Appareil selon la revendication 13, comprenant en outre :
une machine de moulage par injection pour préchauffer les granules de plastique et les injecter dans un moule pour fabriquer le capuchon (12) ;
dans lequel l'outil de surmoulage par injection de la maille est configuré pour surmouler le capuchon (12) sur la partie inférieure d'une section de maille (46) de la deuxième densité de maille.

15. Appareil selon l'une quelconque des revendications 12 à 14, dans lequel l'appareil est configuré pour exécuter le procédé selon l'une quelconque des revendications 1 à 11.
